# EUROPEAN PATENT APPLICATION

(11) **EP 2 293 441 A1**
(43) Date of publication of application: **09.03.2011**
(21) Application number: 09252101.2
(22) Date of filing: 28.08.2009
(51) Int. Cl.: H03K 3/037, H03K 3/356

(54) **Frequency divider**

(71) Applicant: NXP B.V., 5656 AG Eindhoven (NL)
(72) Inventor: Leong, Frank Harald Erich Ho Chung, Surrey RH1 1DL (GB)
(74) Representative: Williamson, Paul Lewis

(57) **Abstract**

A frequency divider circuit (200,300,400) for converting an input clock signal (CLKP,CLKN) at a first frequency to an output clock signal (V_{out,P},V_{out,N}) at a second frequency, the divider circuit comprising: first and second output nodes (206a,206b) for providing the output clock signal (V_{out,P},V_{out,N}); and a negative impedance element (204) having opposing nodes (203a,203b) switchably connected to the respective first and second output nodes (206a,206b) on a first part of a clock pulse of the input clock signal (CLKP,CLKN) and to the first and second output nodes (206a,206b) via an inverter (202a,202b) on a second part of a clock pulse of the input clock signal (CLKP,CLKN).

## Description

The invention relates to frequency dividers for use in generating divided clocking signals.

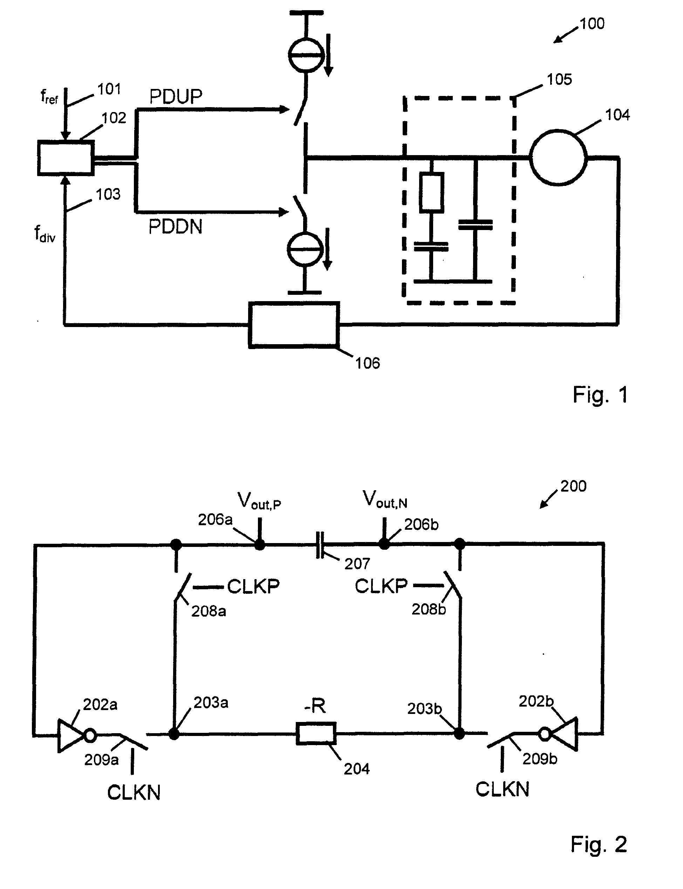

Many electronic circuits, such as integrated RF systems and synchronous digital processors, require some means of carrier/clock generation. This is often done using a high-frequency oscillator in a phase-locked loop, where a carrier/clock signal is locked to a stable frequency reference. An exemplary embodiment of a phase-locked loop circuit 100 is shown in figure 1. The phase of a high frequency clock signal input 101 at a frequency f_{ref} is compared by a phase comparator 102 with the phase of a frequency divided version 103 of the clock signal input 101, at a divided frequency f_{div}. The resulting phase difference, whether positive or negative, drives, via a loop filter 105, a voltage-controlled oscillator 104, which generates a signal fed to a frequency divider 106.

If the high frequency generator (not shown) used to generate the clock signal input 101 includes a resonator tank, its power consumption can be very small. The resonator may operate more efficiently at higher frequencies, in which case the carrier/clock signal may be more efficiently obtained from the resonator by frequency division. In each of these scenarios, the frequency divider 106 is an essential part of the system.

Modulo-2 frequency dividers, which divide an input clock signal frequency in two, are generally the easiest to implement and are usually the first divider in any chain of dividers, with the consequence that such dividers will run at the highest frequency of all dividers in a chain. The power consumption of such a divider is therefore the most critical of all the dividers in the chain.

A frequency divider function is often implemented in Current-Mode Logic (CML), as for example disclosed in reference [5] of the references listed below. CML-implemented dividers can achieve high operating frequencies, but result in a high current consumption. Lower power alternatives exist in the form of CMOS logic implementations, as for example disclosed in references [1] -[5], of which the TSPC (true singlephase clocked) logic type, disclosed in reference [1], is the fastest and the least power-hungry alternative, all other mentioned dividers being differential implementations.

Differential dividers have several benefits over TSPC implementations, including reduced crosstalk and the ability to drive differential loads, such as balanced mixers and transmission gates.

The main disadvantage of existing differential modulo-2 full-CMOS frequency dividers relates to the number of transistors required. Existing known alternatives use 12 or more transistors in a single divider, leading to a larger capacitance and higher complexity, as well as increased chip area. This also translates to a larger current consumption and higher phase noise (or jitter).

One possible solution to the problem of power consumption could be to provide two TSPC dividers run with opposite phase signals. Such an implementation would not however save much power compared to already known true differential dividers, and would put a large (asymmetric) load on the driving clock and a lower limit on the input frequency. Any attempt to remove glitches by topology adjustments will tend to dramatically increase transistor count and power consumption.

It is an object of the invention to address one or more of the above mentioned problems.

In accordance with a first aspect of the invention, there is provided a frequency divider circuit for converting an input clock signal at a first frequency to an output clock signal at a second frequency, the divider circuit comprising:
first and second output nodes for providing the output clock signal;
   and
a negative impedance element having opposing nodes switchably connected to the respective first and second output nodes on a first part of a clock pulse of the input clock signal and to the first and second output nodes via an inverter on a second part of a clock pulse of the input clock signal.

The first and second parts of the clock pulse preferably correspond to two halves of a differential input clock signal becoming high. The reverse, i.e. the clock signal becoming low, could also apply. In general therefore, the two parts of the clock signal are separated by transitions between two distinct states of the input clock signal.

The second frequency is lower than, and preferably half that of, the first frequency.

A particular advantage of the invention is that of simplicity, as fewer transistors are required. A frequency divider according to the invention also results in a lower current consumption and reduced phase noise, and can operate over a very wide frequency range, making the circuit design suitable for divider chains that are adapted to be reconfigurable.

Opposing nodes of the negative impedance element are optionally each switchably connected to the first and second output nodes on the second edge of the clock pulse by a pair of transistors. The pairs of transistors preferably share a common transistor, which allows the transistor count to be reduced further.

The negative impedance element may be realised by a pair of cross-coupled inverters which, in a CMOS implementation, can be provided by a complementary pair of transistors.

The first and second output nodes of the frequency divider may be connected via a capacitor, or alternatively by a second negative impedance element. The second negative impedance circuit preferably comprises a pair of cross-coupled inverters, for example in a similar form to those of the first negative impedance element.

In accordance with a second aspect of the invention there is provided a method of frequency division in a circuit for converting an input clock signal at a first frequency to an output frequency divided clock signal at a second frequency, the method comprising:
applying a first part of a pulse of the input clock signal to cause first and second output nodes of the circuit to be connected across a negative impedance element;
applying a second part of the pulse of the input clock signal to cause the first and second output nodes to each be connected across the negative impedance element via an inverter; and
repeating the above method steps to cause the output frequency divided clock signal to be applied across the first and second output nodes.

Embodiments of the present invention result in a reduced current consumption compared to traditional approaches, typically by approximately 40%. Due to the non-regenerative nature of the frequency divider of the invention, there is effectively no imposed lower limit on the input frequency, which makes the divider particularly suitable for highly reconfigurable divider chains.

The invention is described in further detail below by way of example, and with reference to the accompanying drawings, in which:
figure 1 is a schematic diagram of a known phase-locked loop circuit;
figure 2 is a schematic diagram of a frequency divider according to the invention;
figure 3 is a circuit diagram of a CMOS embodiment of a frequency divider according to the invention; and
figure 4 is a circuit diagram of an alternative CMOS embodiment of a frequency divider according to the invention.

The principle of the invention is illustrated in the schematic circuit diagram of a frequency divider 200 shown in figure 2. The divider circuit 200 comprises two pairs of transmission gates 208a, 208b & 209a, 209b and a pair of inverters 202a, 202b, the transmission gates being operable to alternately switch between two pairs of state nodes, of which a first pair 203a, 203b is connected across a negative impedance element 204 to enforce imbalance, while a second pair 206a, 206b provide the respective differential voltage outputs V_{out,P}, V_{out,N}. The second pair of nodes 206a, 206b are shown in figure 2 connected across a capacitor 207. The capacitor 207 may optionally be replaced by a second negative impedance element in certain embodiments.

The input differential clock signal in the divider circuit 200 in figure 2 is represented by CLKP and CLKN. When CLKP is high, switches 208a, 208b are closed, connecting the output nodes 206a, 206b across the negative impedance element 204. Once switches 208a, 208b close, the state on nodes 203a, 203b transfers to the output nodes 206a, 206b. Because the negative impedance element 204 enforces an imbalance between nodes 203a, 203b, the state on the nodes is such that while one node is high the other is low. When CLKN is high (and, by definition, CLKP low), switches 209a, 209b are closed, connecting the output nodes 206a, 206b across the negative impedance element 204 via respective inverters 202a, 202b. At the same time, switches 208a, 208b open. The outputs of the inverters 202a, 202b therefore cause the state across the negative impedance element 204 to switch. This is possible when the output resistances of the inverters 202a, 202b are lower than the absolute value of the resistance of the negative impedance element 204. The overall effect of the circuit is that the state of each pair of state nodes 206a, 206b, 203a, 203b changes only once in each clock cycle, resulting in the frequency of the output signal defined by V_{out,P}, V_{out,N} being half the frequency of the input clock signal.

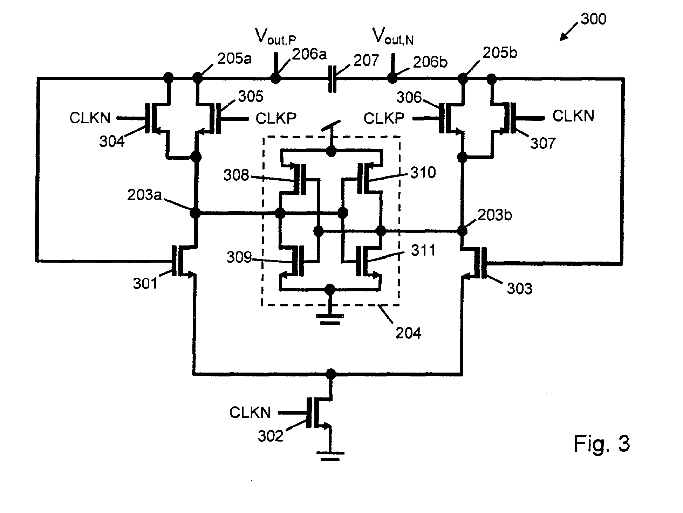

A CMOS implementation of the divider circuit 200 of figure 2 is illustrated in the divider circuit 300 in figure 3. In this embodiment the switched inverters 202a, 202b of figure 2 are provided by NMOS transistors 301, 303, which share a common source-switch in the form of NMOS transistor 302. The negative impedance element 204 is provided by a pair of cross-coupled inverters comprising transistors 308, 309 in a first inverter and transistors 310, 311 in a second inverter. The cross-coupled inverters are employed in a similar fashion to that disclosed in reference [6]. An output buffer (not drawn) also serves as the state capacitor 207. In the circuit 300 of figure 3 a total of 11 transistors is required.

The embodiment shown in figure 3 compares favourably with known frequency dividers solutions. For a low-noise application in a 0.14µm CMOS process, a comparison can be made between a frequency divider according to the invention and existing CML frequency divider circuits, as for example disclosed in reference [5]. The comparison is shown in Table 1 below. This comparison was made on modulo-2 prescalers operating with a supply of 1.8V and an input frequency of 1.8 GHz and at a temperature of 125 °C. The results indicate that the current requirements for the divider according to the invention are significantly lower than existing solutions, and the phase noise is significantly smaller.

**Table 1: Comparison between modulo-2 prescalers**

| **Prescaler Type:** | Current Invention | CML (with resistors) | CML (without resistors) |
|---|---|---|---|
| **Current @2.8GHz** | 134.9 | 210.3 | 222.6 |
| **/** µ**A:** | | | |
| **Phase Noise @100kHz** | -140.3 | -134.7 | -131.4 |
| **/ dBc/Hz:** | | | |

A divider circuit according to the embodiment shown in figure 3, when optimized for 1.8GHz, can operate at frequencies as low as 1.8kHz, at which point leakage effects start to become significant, mainly due to the transmission gate switches. The circuit can therefore be used over more than six full decades of input frequencies, which allows the divider to be used interchangeably in different stages of a multiple divider circuit.

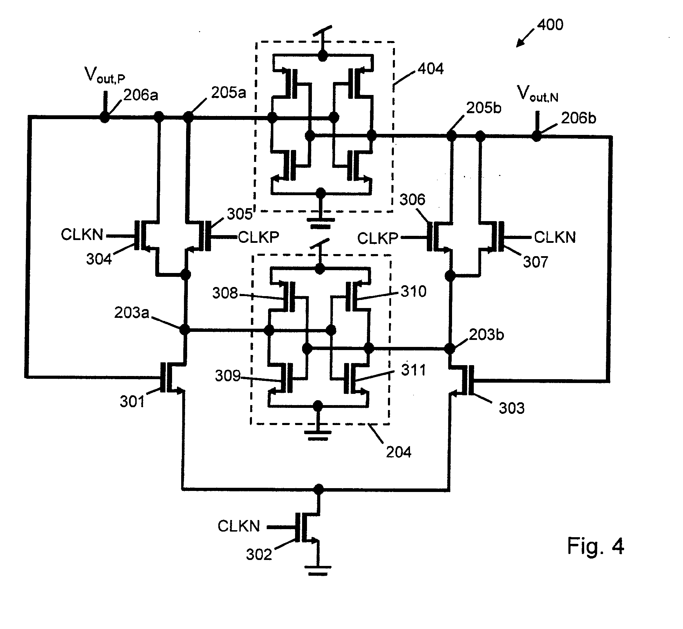

In alternative embodiments, the divider circuit may be made more immune to leakage current and more resilient to outside disturbances through the use of an additional negative impedance element in the form of a second cross-coupled inverter pair 404 to replace the state capacitor 207 in the circuit of figure 3. This alternative solution is shown in the circuit diagram of figure 4. The circuit components of this frequency divider 400, including the transistors making up the cross-coupled pair of inverters forming the second negative impedance element 404, otherwise correspond to those shown in figure 3, described above. The second negative impedance element 404 is preferably smaller than the first negative impedance element 204, or in other words the transconductance of each of the transistors making up the second negative impedance element 404 is lower and the impedance is higher than that of the transistors making up the first negative impedance element 204. This may be achieved by the transistors of the second negative impedance element 404 having smaller channel widths than those of the first negative impedance element 204. As a result, the smaller negative impedance element 404 will be dominated by the larger negative impedance element 204, which is important for proper operation of the frequency divider circuit 400. One possible disadvantage of this alternative embodiment is that it requires scaling of the first inverter 204. This could increase current consumption in some applications because the inverter, and therefore also its parasitic capacitance, may be significantly larger than the minimum dictated by the design rules of a process.

A frequency divider according to the invention may be applicable to many different systems, particularly those in which differential modulo-2 prescalers are required. Example applications include RF transceivers such as those used in Bluetooth, WLAN, FM radio, DAB, TV, DVB, GSM, EDGE, WCDMA, UMTS, HSDPA, UWB, ZigBee, RFID and remote key entry systems, data converters, or digital processors.

Other embodiments are intentionally within the scope of the invention as defined by the appended claims.

### References

[1] J. Yuan and C. Svensson, "High-speed CMOS circuit technique," IEEE JSSC, Feb. 1989.
[2] N. Weste and K. Eshraghian, "Principle of CMOS VLSI Design: A Systems Perspective," Addison-Wesley Publishing Co., 1992.
[3] M. Fujishima et al., "Low-Power 1/2 Frequency Dividers Using 0.1-µm CMOS Circuits Built with Ultrathin SIMOX Substrates," IEEE JSSC, Apr. 1993.
[4] B. Razavi et al., "A 13.4-GHz CMOS Frequency Divider," IEEE ISSCC, 1994.
[5] M. Pierschel, "Frequenzteiler mit niedriger Leistungsaufnahme", Ph.D. dissertation, BTU Cottbus, 2002.
[6] A. Ghadiri and H. Mahmoodi, "Dual-Edge Triggered Static Pulsed Flip-Flops," Proc. 18th VLSID, Taj Benjal, Kolkata, India, Jan. 2005.

## Claims

1. A frequency divider circuit (200,300,400) for converting an input clock signal (CLKP,CLKN) at a first frequency to an output clock signal (V_{out,P},V_{out,N}) at a second frequency, the divider circuit comprising:
first and second output nodes (206a,206b) for providing the output clock signal (V_{out,P},V_{out,N}); and
a negative impedance element (204) having opposing nodes (203a,203b) switchably connected to the respective first and second output nodes (206a,206b) on a first part of a clock pulse of the input clock signal (CLKP,CLKN) and to the first and second output nodes (206a,206b) via an inverter (202a,202b) on a second part of a clock pulse of the input clock signal (CLKP,CLKN).

2. The frequency divider circuit (300,400) of claim 1 wherein each inverter (202a,202b) comprises a pair of transistors (301,302;303,302).

3. The frequency divider circuit (300,400) of claim 2 wherein each pair of transistors (301,302;303,302) share a common transistor (302).

4. The frequency divider circuit (300,400) of any preceding claim wherein the negative impedance element (204) comprises a pair of cross-coupled inverters.

5. The frequency divider circuit (300,400) of claim 4 wherein each inverter of the pair of cross-coupled inverters (204) comprises a complementary pair of transistors (308,309;310,311).

6. The frequency divider circuit (200, 300, 400) of any preceding claim wherein an output resistance of each inverter (202a, 202b) is lower than an absolute value of a resistance of the negative impedance element (204).

7. The frequency divider circuit (200,300) of any preceding claim wherein the first and second output nodes (206a,206b) are connected via a capacitor (207).

8. The frequency divider circuit (400) of any one of claims 1 to 6 wherein the negative impedance element (204) is a first negative impedance element and the first and second output nodes are connected via a second negative impedance element (404).

9. The frequency divider circuit of claim 8 wherein the second negative impedance element (404) comprises a pair of cross-coupled inverters.

10. The frequency divider circuit of claim 9 wherein transistors comprising the second negative impedance element have a lower transconductance and a higher impedance than transistors comprising the first negative impedance element.

11. The frequency divider circuit of any preceding claim wherein the second frequency is half that of the first frequency.

12. A method of frequency division in a circuit (200,300,400) for converting an input clock signal (CLKP,CLKN) at a first frequency to an output frequency divided clock signal (V_{out,P},V_{out,N}) at a second frequency, the method comprising:
applying a first part of a pulse of the input clock signal (CLKP,CLKN) to cause first and second output nodes (206a,206b) of the circuit (200,300,400) to be connected across a negative impedance element (204);
applying a second part of the pulse of the input clock signal (CLKN,CLKP) to cause the first and second output nodes (206a,206b) to each be connected across the negative impedance element (204) via an inverter (202a,202b); and
repeating the above method steps to cause the output frequency divided clock signal to be applied across the first and second output nodes (206a,206b).
